# FASCICULE DE BREVET EUROPEEN

(11) **EP 2 541 260 B1**
(45) Date de publication et mention de la délivrance du brevet: **31.10.2018**
(21) Numéro de dépôt: 12354030.4
(22) Date de dépôt: 22.05.2012
(51) Int. Cl.: G01R 15/14, G01R 15/18, H01F 38/36, G01R 11/04, G01R 21/06, H01H 71/12

(54) **Dispositif de mesure du courant électrique circulant dans un appareillage électrique, ledit dispositif permettant la mesure d'energie**
Energiemessung ermöglichende Vorrichtung zum Messen des durch ein Elektrogerät fließenden Stroms
Device for measuring the electric current circulating in electrical equipment, said device enabling the measurement of energy

(30) Priorité: 28.06.2011 FR 1101985
(43) Date de publication de la demande: 02.01.2013
(73) Titulaire: Schneider Electric Industries SAS, 92500 Rueil-Malmaison (FR)
(72) Inventeur: Moliton, Vivien, 38050 Grenoble Cedex 09 (FR); Buffat, Sébastien, 38050 Grenoble Cedex 09 (FR)
(74) Mandataire: Colette, Marie-Françoise

(56) Documents cités:
- EP-A1- 2 282 321
- EP-A2- 0 528 634
- WO-A1-2008/144161
- DE-A1-102006 059 384
- FR-A1- 2 891 946
- US-A- 4 286 213
- US-A- 4 558 310

## Description

La présente invention concerne un dispositif de mesure d'au moins une grandeur électrique comportant le courant électrique circulant dans un appareillage électrique, ledit appareillage étant logé dans un boîtier destiné à être monté sur un support de montage, ainsi qu'un appareillage électrique comportant un tel dispositif.

On connaît des appareils de protection électrique comportant des dispositifs de mesure de l'énergie intégrés situés à l'intérieur des boîtiers desdits appareils.
Dans ces appareils, la mesure du courant et de la tension s'effectue donc de manière intrusive, puisque les moyens de mesure sont à l'intérieur des appareils.
On connaît le document EP 0 528 634 décrivant un dispositif comportant les caractéristiques du préambule de la revendication 1.
On connaît également le document FR 2 891 946 décrivant un dispositif de mesure d'un courant électrique.

La présente invention résout ce problème et propose un dispositif de mesure du courant et de la tension de conception simple pouvant être associé à un appareil de protection électrique standard monté sur un support de montage, par exemple de type « rail DIN », ledit dispositif s'intégrant dans un volume disponible réduit en largeur à celle de l'appareillage de protection tout en répondant aux objectifs de précision de mesure de classe 2, la mesure du courant étant réalisée de manière non intrusive sans que l'accès direct habituel des fils électriques connectés aux bornes dudit appareil ne soit empêché ni contraint, ni rajouter de connexions, ainsi qu'un appareil de protection électrique comportant un tel dispositif.

A cet effet, la présente invention a pour objet un dispositif de mesure selon la revendication 1.

Selon une caractéristique particulière, la(les) partie(s) précitée(s) délimitant l'(les) orifice(s) traversant(s) présente(ent) une section transversale en forme de U.

Selon une caractéristique particulière, le noyau magnétique précité comporte deux U séparés par deux entrefers, une bobine secondaire de mesure étant placée autour de chacun des deux entrefers, lesdites bobines étant connectées en série et délivrant un signal représentatif du courant circulant dans l'appareil.

Selon une autre caractéristique, les U magnétiques précités sont réalisés avec un fil rond étiré présentant un diamètre d'environ 1mm.

Selon une autre caractéristique, les U magnétiques sont réalisés en Fe Si ou en Fe Ni.

Selon une autre caractéristique, les U magnétiques sont réalisés par empilage d'un certain nombre de couches de matériau nanocristallin.

Selon une autre caractéristique, le noyau magnétique est constitué par une pièce en forme de U comportant deux parties d'extrémités séparées par un entrefer, entre lesquelles est placée une bobine secondaire de mesure du courant circulant dans l'appareillage.

Selon une autre caractéristique, ce noyau magnétique est composé de trois branches soudées entre elles, ces trois branches étant formées par l'empilage de tôles.

Selon une autre caractéristique, les branches du U sont réalisées en Fe Si 3 % à grain orienté (FGO).

Selon une autre caractéristique, le noyau magnétique précité est composé de deux I séparés formant entre eux à leurs extrémités, deux entrefers, chaque I étant apte à canaliser le flux magnétique, chaque entrefer étant formé par deux parties d'extrémités en regard des deux I, chaque entrefer recevant une bobine secondaire de mesure disposée entre deux parties d'extrémités en regard appartenant respectivement aux deux I.

Selon une autre caractéristique, chaque I est formé par l'empilage de tôles, réalisées en FeSi 3% à grain orienté (HGO).

Selon une autre caractéristique, l'extrémité des branches des I dépasse les bobines d'une longueur sensiblement égale à la largeur du circuit magnétique, de manière à minimiser l'influence possible des champs magnétiques extérieurs.

Selon une autre caractéristique, ce dispositif est monté à l'intérieur d'un boîtier dit premier, apte à être fixé de manière amovible au boîtier dit second de l'appareillage.

Selon une autre caractéristique, le boîtier dit premier précité comporte deux fiches en saillie à partir d'une face extérieure dudit boîtier, lesdites fiches étant destinées d'une part, par l'une dite première de leurs extrémités, à permettre la prise de tension sur les plages des bornes de l'appareillage, et d'autre part, à assurer le maintien du boîtier dit premier par rapport au boîtier dit second, lesdites fiches étant reliées électriquement par leur extrémité opposée à des moyens de mesure de la tension.

Selon une autre caractéristique, les fiches sont reliées électriquement à une carte électronique comportant les moyens de mesure de la tension précités.

Selon une autre caractéristique, au moins une partie des éléments situés à l'intérieur du boîtier dit premier, sont enrobés dans une résine à forte tenue diélectrique permettant de réduire les distances d'isolement à l'intérieur dudit boîtier.

Selon une autre caractéristique, l'appareil est un appareil de protection électrique modulaire destiné à être monté sur un rail de support.

La présente invention a encore pour objet un appareil de protection électrique comportant un dispositif de mesure comportant les caractéristiques précédemment mentionnées prises seules ou en combinaison.

Mais d'autres avantages et caractéristiques de l'invention apparaîtront mieux dans la description détaillée qui suit et se réfère aux dessins annexés donnés uniquement à titre d'exemple et dans lesquels :
- La figure 1 illustre, dans une vue en perspective, un dispositif de mesure prêt à être monté sur un appareillage,
- La figure 2 est une vue similaire à la figure précédente, montrant certains éléments de la partie intérieure du dispositif,
- La figure 3 est une vue en perspective, illustrant plus complètement, par transparence des parois, les éléments intérieurs dudit dispositif,
- La figure 4 est une vue similaire à la figure 3, mais illustrant l'enrobage des éléments intérieurs du dispositif selon une réalisation particulière de l'invention,
- La figure 5 est une vue partielle en perspective, illustrant seulement les éléments intérieurs présents sur les figures 2 et 4,
- La figure 6 est une vue partielle en perspective, illustrant la partie inférieure du boîtier du dispositif selon l'invention, comportant deux bornes ou orifices traversants dont l'une est équipée d'un capteur de courant,
- La figure 7 est une vue partielle illustrant seulement le capteur de courant comportant le noyau et les deux bobines,
- La figure 8 est une vue partielle illustrant la bobine et ses conducteurs de sortie,
- Les figures 9,10 et 11 illustrent dans une vue en perspective trois formes de réalisation différentes du capteur de courant selon l'invention,
- La figure 12 est une vue similaire à la figure 9, mais montrant l'entrefer par transparence de la bobine,
- Les figures 13 et 14 sont des vues partielles en perspective, illustrant la partie intérieure d'un appareillage électrique équipé d'un dispositif de mesure selon l'invention, respectivement dans une position dans laquelle le conducteur n'est pas encore introduit dans le dispositif et dans une position dans laquelle le conducteur est déjà introduit dans le dispositif.

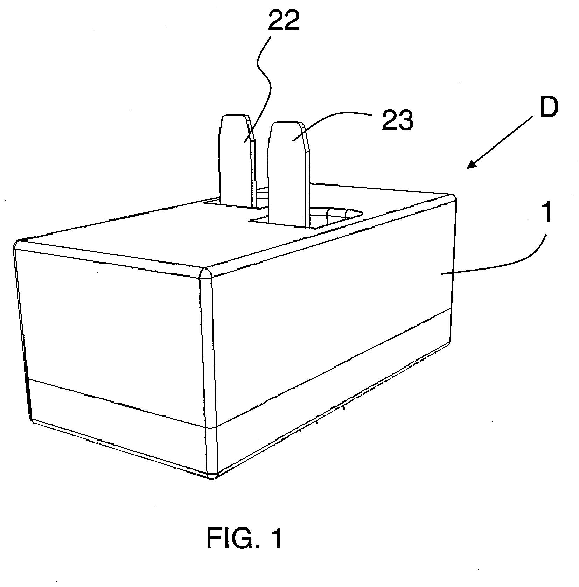

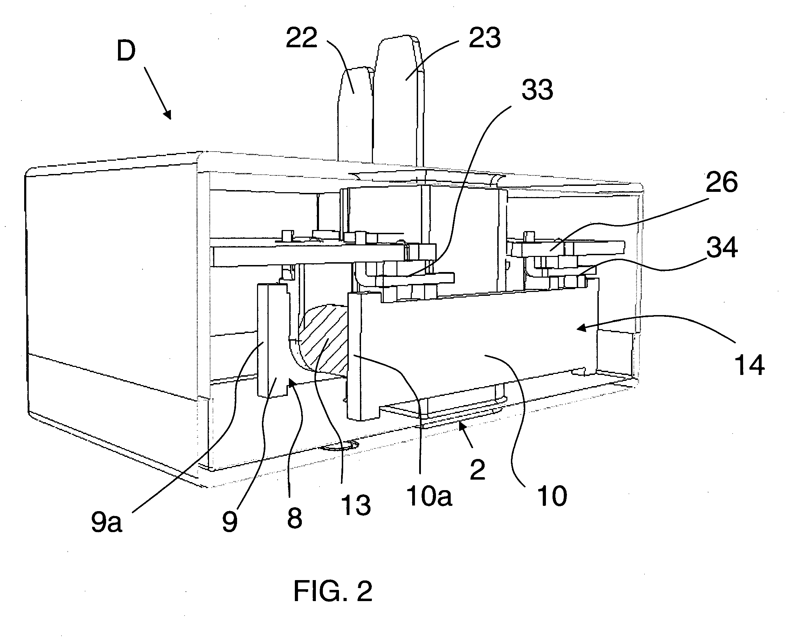

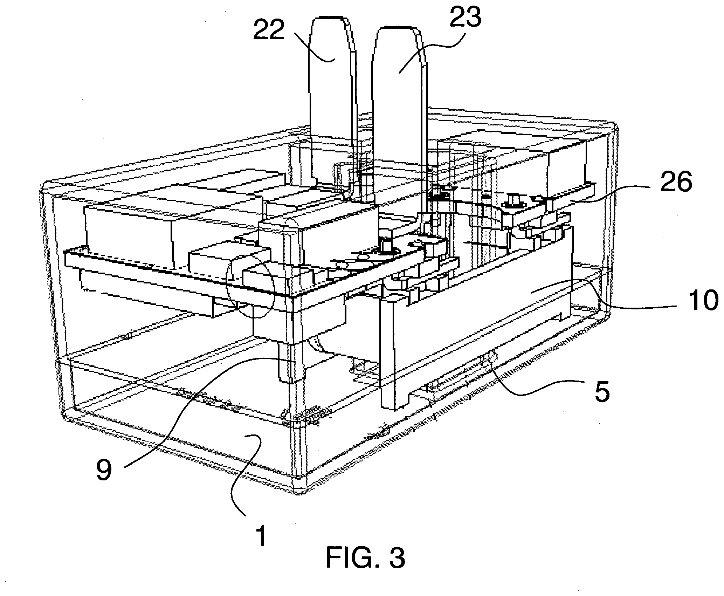

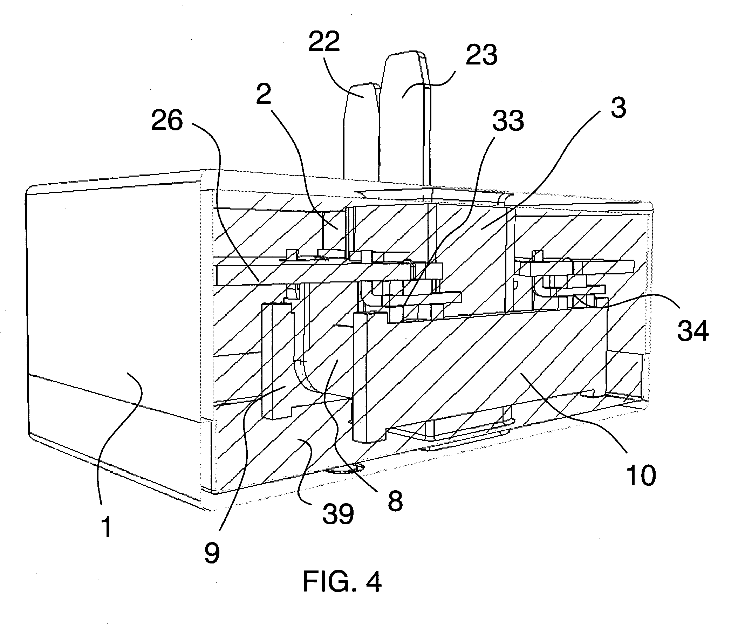

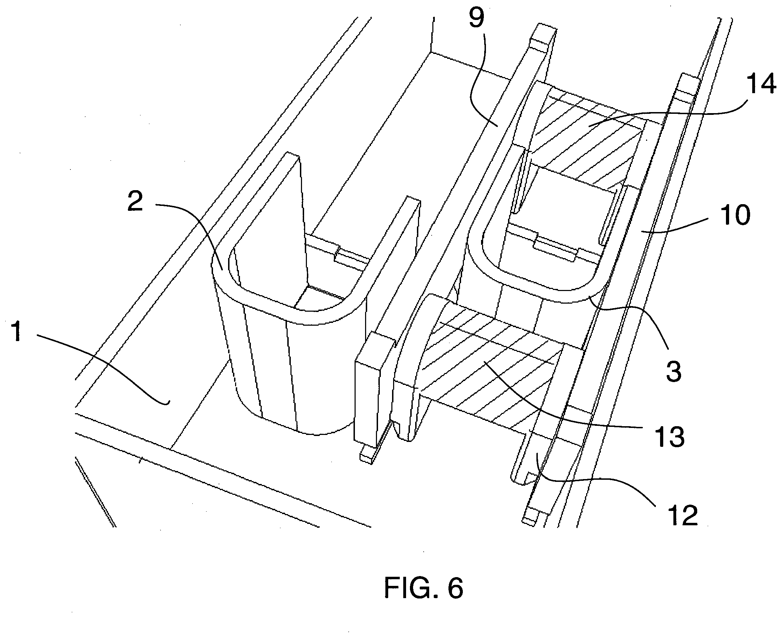

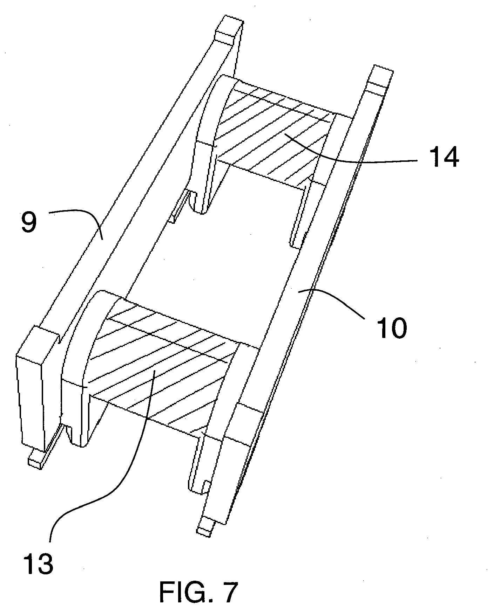

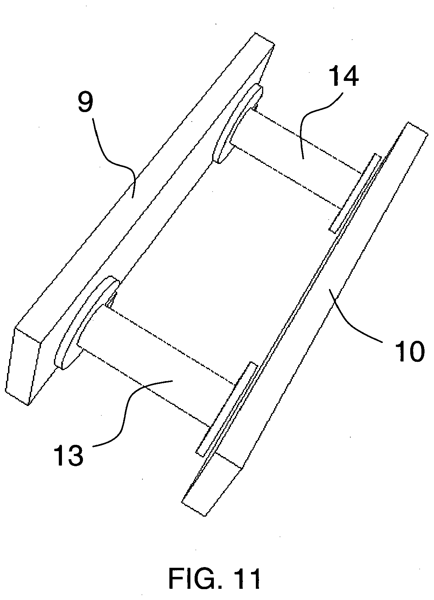

Sur les figures 1 à 4, on voit un dispositif D de mesure d'un courant électrique et de la tension selon l'invention, destiné à être associé à un appareillage électrique de manière à mesurer le courant et la tension circulant dans ledit appareil. Ce dispositif est logé dans un boîtier 1 de forme sensiblement parallélépipédique d'une largeur sensiblement égale à celle de l'appareil de protection et d'une hauteur permettant de l'intégrer entre deux lignes d'appareillages installées et câblées dans une armoire électrique sur des rails séparés par une hauteur standard, ledit boîtier 1 renfermant deux orifices traversants formant bornes 2,3 solidaires de la paroi inférieure du boîtier, lesdites bornes étant situées en regard de deux orifices 5 prévues dans la paroi inférieure du boîtier, lesdits orifices 5 étant destinés à permettre le passage respectivement de deux conducteurs (non représentés), lesdits conducteurs électriques étant destinés à relier électriquement les plages de contact dudit appareillage avec les bornes d'un appareil (non représenté) situé en aval ou en amont. Tel que ceci est particulièrement illustré sur les figures 1 à 8 et 11, ce dispositif de mesure comporte un capteur, ledit capteur étant constitué dans cette forme particulière illustrée de réalisation, d'un noyau magnétique 8 (fig.2) composé de deux I 9,10 séparés par une certaine distance correspondant à la longueur de deux parties de supports 12 de deux bobines 13,14 interposés respectivement chacune entre deux extrémités en regard des deux I. Ces bobines secondaires viennent s'insérer entre les tôles, de préférence vers les extrémités des branches des I. La mesure par la bobine est réalisée dans l'air au niveau des entrefers. Les extrémités des branches des I dépassent les bobines d'une longueur supérieure au minimum requis pour le montage des bobines au bout des branches des I afin de minimiser l'influence possible des champs magnétiques extérieurs qui pourraient perturber les mesures. On notera qu'avantageusement, l'ordre de grandeur du dépassement sera une longueur égale à la largeur du circuit magnétique. Ces dépassements agissent comme écrans magnétiques aux rayonnements magnétiques extérieurs à celui du conducteur traversant le capteur. Ces I sont des tôles qui ont pour fonction de canaliser le flux magnétique jusqu'aux entrefers nécessaires à la mesure du courant pour que le rapport entre le courant mesuré et son image à la sortie du bobinage soit linéaire depuis une faible valeur du courant à mesurer jusqu'à une forte valeur, la dynamique allant d'une mesure d'environ de 100mA jusqu'à 400A voir 4000. Ceci permet de placer les bobines dans des zones du boîtier d'un volume suffisant pour pouvoir les contenir. Or, Il n'y a que sensiblement 1mm entre les cloisons des deux orifices traversant le boîtier. Dans le cas d'une réalisation comportant une bobine avec un noyau à air, il n'est pas possible d'entourer l'orifice avec une bobine car la distance qui sépare les deux bornes de l'appareil de protection est trop faible.

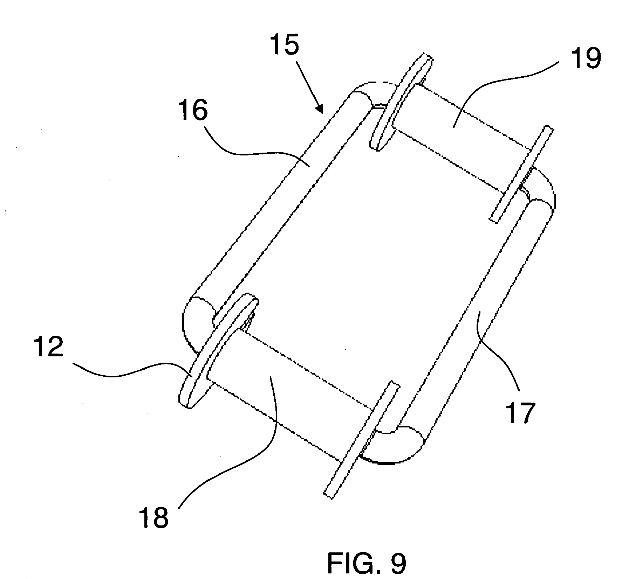

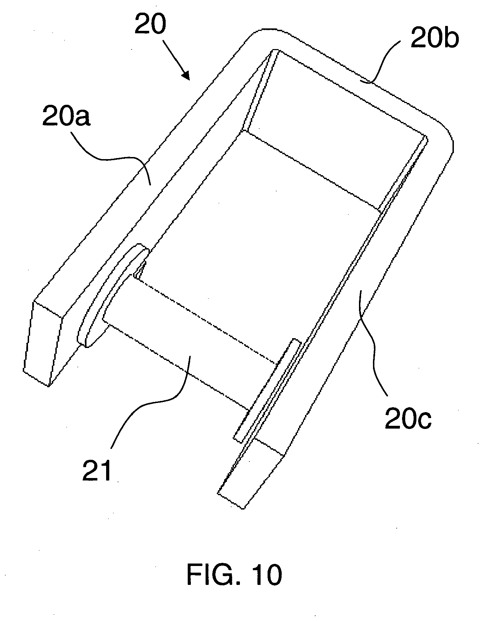

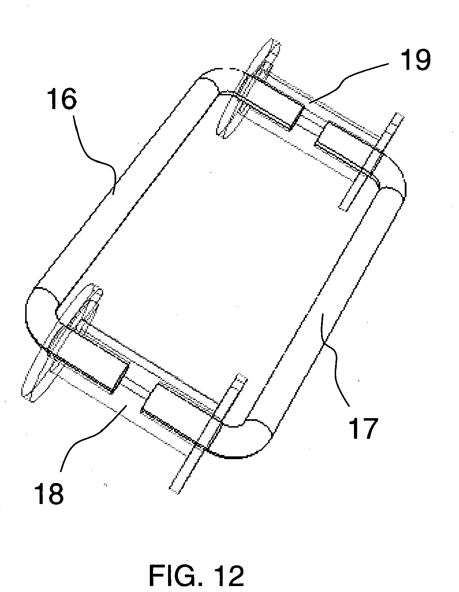

Chaque I est formé par l'empilage de tôles (par exemple trois tôles de 0.3mm d'épaisseur), ou bien par une seule grosse tôle ou bien une seule tôle réalisée en matériau fritté. Ce matériau est avantageusement du FeSi3% à grain orienté (HGO). Ce capteur, dans cette réalisation, est très peu sensible aux perturbations extérieures grâce aux tôles et à leur dépassement. Ce capteur est également insensible au positionnement du câble primaire grâce aux deux bobines. L'épaisseur des I est d'environ 1 mm.
Selon une autre réalisation du capteur de courant illustrée sur les figures 9 et 12, ce capteur est composé de deux parties. La première partie comporte un noyau magnétique 15 composé de deux U 16,17 séparés par deux entrefers. La seconde partie comporte deux bobines de mesure 18,19 montées autour desdits entrefers, lesdites bobines étant connectées en série et délivrant un signal dérivé image du courant primaire.
Afin de satisfaire les contraintes géométriques, les U magnétiques 16,17 peuvent être réalisés avec un fil rond étiré d'un diamètre de 1 mm, ou n'importe quelle autre forme, un type de matériau utilisable étant FeSi ou FeNi. Afin d'améliorer la linéarité du capteur, les U magnétiques pourront être réalisés en nanocristallin, par empilage d'un certain nombre de couches de nanocristallin de très faible épaisseur. Cette réalisation permet d'obtenir un gain important grâce à la présence de matériau sous les bobines, et est insensible au positionnement du câble primaire grâce à la présence des deux bobines.
Selon une autre réalisation illustrée sur la figure 10, ce capteur comporte un noyau magnétique 20 en forme de U composé de trois branches 20a,20b,20c soudées entre elles, ces trois branches étant elles-mêmes formées par l'empilage de tôles (par exemple trois tôles de 0.3 mm d'épaisseur), ce matériau pouvant être du feSi3% à grain orienté (HGO). L'épaisseur des branches du U est d'environ 1 mm.
Dans ce cas, une seule bobine 21 est nécessaire et de la même manière que pour les cas précédemment décrits, la bobine secondaire 21 vient s'insérer au bout des branches du U 20 avec un entrefer le plus petit possible, le bout des branches du U devant dépasser la bobine 20 pour minimiser l'influence possible de champs magnétiques extérieurs.
Tel qu'illustré sur les figures 1 à 5 et 13,14, le dispositif selon l'invention comporte également deux fiches 22,23 dont la fonction est d'une part, de prendre la tension au niveau des bornes de l'appareillage et d'autre part, de permettre le maintien du boîtier 1 du dispositif selon l'invention par rapport au boîtier de l'appareillage après introduction des dites fiches 20,21 dans lesdites bornes. Ces fiches comportent donc une extrémité destinée à être raccordée à ladite borne et une extrémité destinée à être fixée et reliée électriquement à une carte électronique 26 de traitement des données.

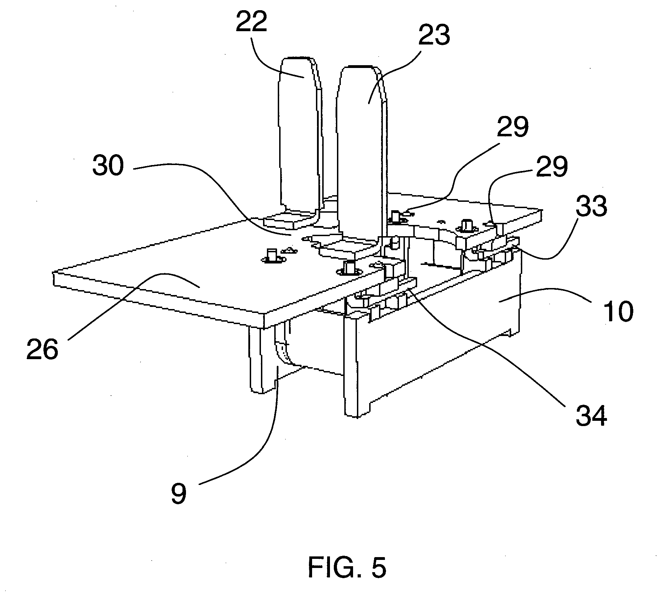

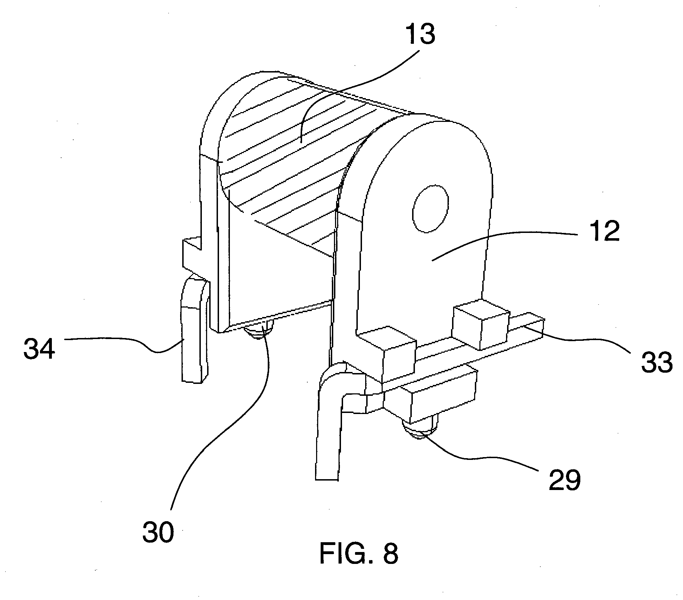

En se reportant plus particulièrement aux figures 5 et 8, on voit également que le support 12 constitué par une carcasse de bobine 13,14 est fixé sur la carte électronique 26 au moyen de plots 29,30 solidaires dudit support de bobine 11,12 et coopérant avec des ouvertures prévues sur la carte électronique 26.
En se reportant aux figures 5 et 8, on voit également que le dispositif comporte également des éléments de raccordement électriques 33,34 des extrémités de la bobine 13 à la carte électronique.
On notera que l'alimentation capacitive et la mesure de tension par diviseur résistif impose de tenir des niveaux CEM et donc des distances d'isolement.
Ainsi, pour s'affranchir ou tout du moins réduire ces distances d'isolement, les éléments intérieurs du dispositif et en particulier la carte électronique, ont été enrobées 39 à l'aide d'une résine à forte tenue diélectrique (par exemple 19kV/mm) permettant de réduire ces distances jusqu'à permettre d'intégrer tous les composants électroniques et le capteur dans le boîtier, et ainsi de réaliser une mesure d'énergie dans un dispositif de très faible taille correspondant à la largeur du boîtier de l'appareil de protection et insérable entre deux lignes d'appareils montés et câblés sur rails dans une armoire.

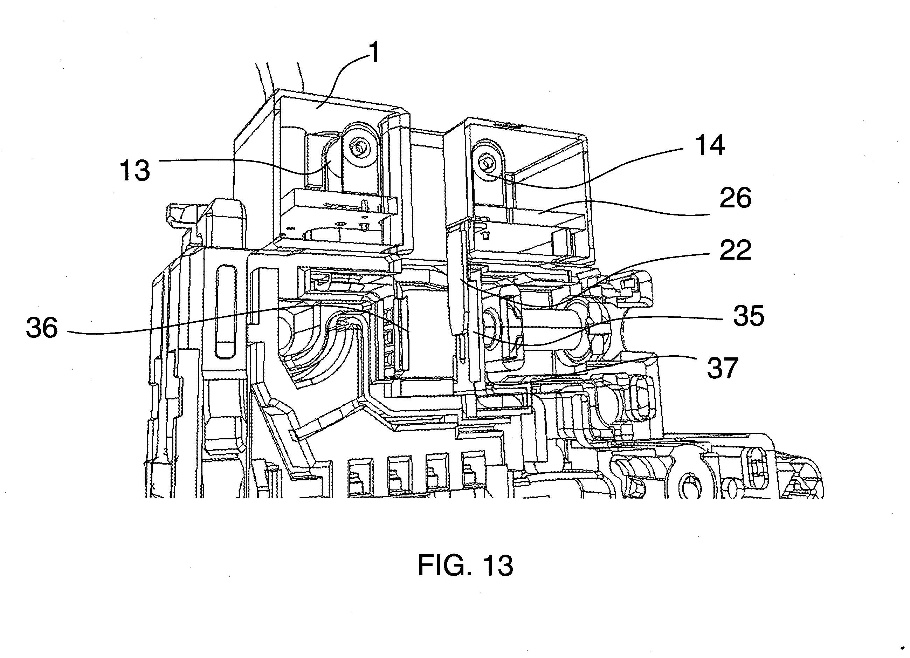

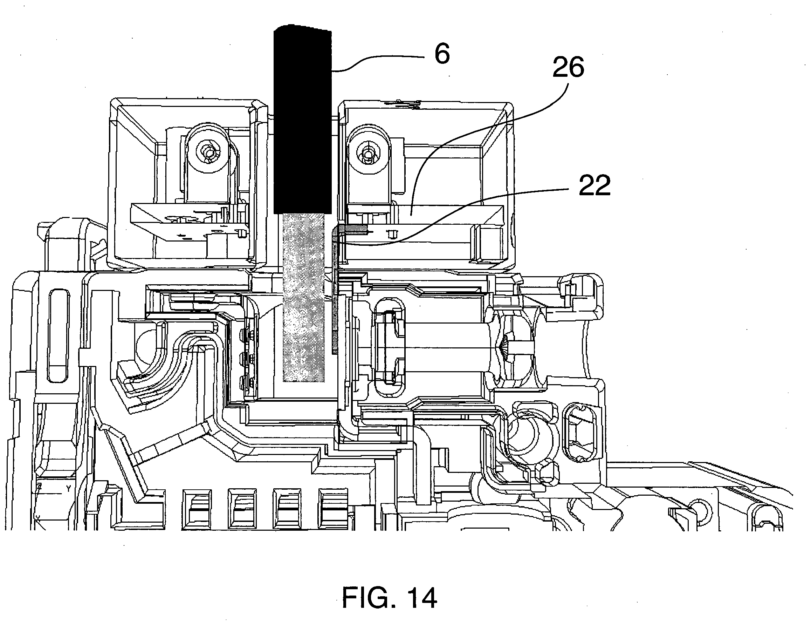

Sur les figures 13 et 14, le dispositif de mesure du courant selon l'invention est monté sur l'appareillage. Dans cette position, les fiches de maintien 22,23 sont introduites dans les bornes de l'appareillage et sont en appui sur deux faces 35 appartenant respectivement aux deux bornes de manière à réaliser le maintien du boîtier 1 du dispositif D par rapport au boîtier de l'appareillage. Dans cette position, les fiches sont également en contact électrique avec les plages 37 des bornes de l'appareillage de manière à permettre la prise de tension.
Sur la figure 13, aucun conducteur n'est introduit dans le dispositif, tandis que sur la figure 14, un conducteur 6 traverse le dispositif pour se raccorder à la borne de l'appareillage et réaliser ainsi le raccordement électrique entre ledit appareillage et un appareil électrique situé en aval ou en amont de ce dernier (non représenté). Dans cette position, les bobines alimentées au moyen d'un couplage magnétique délivrent un signal dérivé qui correspond à l'image du courant primaire.
Ce dispositif permet de réaliser la mesure du courant et de la tension et le calcul de l'énergie, d'une branche (ou départ) d'une installation électrique protégée ou sectionnée par un appareillage. L'encombrement de ce produit est très limité. La mesure du courant se fait de manière non intrusive, c'est-à-dire sans cacher les bornes de l'appareillage ni rajouter de bornes de connexions. Le capteur peut être inséré dans le circuit de n'importe quel appareillage de protection ou de sectionnement existant sans aucune modification de ceux-ci ou de l'installation électrique, ce qui donne une grande flexibilité au fabricant de l'appareillage et à l'installateur.

On a donc réalisé grâce à l'invention, un capteur miniature s'intégrant dans le volume disponible, permettant de s'affranchir des contraintes d'encombrement et répondant aux objectifs de précision de mesure en classe 2 (voir 1 ou 0,5 en fonction de la dynamique) pour des courants pouvant varier de 1 à 4000, et un capteur ayant un compartiment linéaire pour cette variation de courant.
L'invention a permis la miniaturisation du capteur grâce à l'emploi d'un circuit magnétique qui permet de déporter l'entrefer dans une zone où l'on peut placer les bobines.
On notera que ce dispositif pourra être monté seul, associé à un disjoncteur, ou intégré dans un disjoncteur.
On notera également que ce dispositif ne se limite pas à la mesure du courant. Il réalise également la mesure de la tension et le calcul de la puissance et de l'énergie.
On notera également que les trois branches du U peuvent être réalisées de différentes manières à savoir, en un seul bloc fritté, au moyen de tôles pliées ou bien de tôles soudées.

On notera que dans le cas d'un capteur monophasé, on ne mettra qu'un seul capteur (noyau magnétique), alors que dans le cas d'un capteur comportant plusieurs phases, on mettra autant de capteurs que de phases.

L'invention s'applique donc particulièrement à la mesure d'énergie dans un tableau électrique, mais peut s'appliquer à tout appareil pour lequel il est nécessaire de mesurer le courant le traversant ainsi que la tension et l'énergie.

Bien entendu, l'invention n'est pas limitée aux modes de réalisations décrits et illustrés qui n'ont été donnés qu'à titre d'exemple.

C'est ainsi par exemple, que les fils du U magnétique pourront présenter une autre section qu'une section ronde, par exemple pourront être de section carrée, rectangulaire, etc...

Les U magnétiques pourront être réalisés en un autre matériau qu'en FeSi ou en Fe Ni. En effet, ceux-ci pourront être réalisés en un matériau nanocristallin.

## Revendications

1. Dispositif de mesure d'au moins une grandeur électrique comportant le courant électrique circulant dans un appareillage électrique dit premier, ledit appareillage étant destiné à être monté sur un support de montage, ce dispositif de mesure étant logé dans un boîtier dit premier (1) de forme sensiblement parallélépipédique d'une largeur sensiblement égale à celle de l'appareillage précité et d'une hauteur permettant de l'intégrer entre deux lignes d'appareillages montés respectivement sur deux rails dans une armoire électrique, ledit boîtier dit premier comportant un certain nombre d'orifices traversant (2,3) formant des bornes délimités par une partie réalisée en un matériau isolant, ce nombre correspondant au nombre de phases de l'appareillage, lesdits orifices (2,3) étant destinés à être traversés chacun par un conducteur (6), lesdits conducteurs (6) étant destinés à être reliés électriquement par l'une de leurs extrémités respectivement aux plages (37) des bornes de l'appareillage dit premier, et par leur extrémité opposée, aux plages électriques d'un appareillage dit second situé en aval ou bien en amont dudit appareillage dit premier et, pour au moins l'une des bornes du dispositif, un noyau magnétique (8,15,20) entourant au moins partiellement ladite borne et comportant au moins un entrefer autour duquel au moins une bobine de mesure dite secondaire (13,14,18,19,21) est bobinée, la(les) dite(s) bobine(s) de mesure délivrant un signal représentatif du courant circulant dans l'appareil,
**caractérisé en ce que** la(les) dite(s) bobine(s) est(sont) bobinée(s) entre les deux portions d'extrémités du noyau magnétique (8,15,20) délimitant ledit entrefer, et **en ce que** le boîtier dit premier (1) est apte à être fixé de manière amovible à un boîtier dit second appartenant à l'appareillage dit premier, le boîtier dit premier précité (1) comportant deux fiches (22,23) en saillie à partir d'une face extérieure dudit boîtier dit premier (1), lesdites fiches (22,23) étant destinées d'une part, par l'une dite première de leurs extrémités, à permettre la prise de tension sur les plages (37) des bornes (22) de l'appareillage dit premier, et d'autre part, à assurer le maintien du boîtier (1) dit premier par rapport au bottier dit second de l'appareillage, lesdites fiches (22,23) étant reliées électriquement par leur extrémité opposée à des moyens de mesure de la tension.

2. Dispositif de mesure selon la revendication 1, **caractérisé en ce que** la(les) partie(s) précitée(s) délimitant l'(les) orifice(s) traversant(s) présente(ent) une section transversale en forme de U.

3. Dispositif de mesure selon la revendication 1 ou 2, **caractérisé en ce que** le noyau magnétique précité (15) comporte deux U (16,17) séparés par deux entrefers, une bobine secondaire de mesure (18,19) étant placée autour de chacun des deux entrefers, lesdites bobines étant connectées en série et délivrant un signal représentatif du courant circulant dans l'appareillage électrique.

4. Dispositif de mesure selon la revendication 3, **caractérisé en ce que** les U magnétiques précités (16,17) sont réalisés avec un fil rond étiré présentant un diamètre d'environ 1mm.

5. Dispositif de mesure selon la revendication 3 ou 4, **caractérisé en ce que** les U magnétiques (16,17) sont réalisés en Fe Si ou en Fe Ni.

6. Dispositif de mesure selon l'une quelconque des revendications 3 à 5, **caractérisé en ce que** les U magnétiques sont réalisés par empilage d'un certain nombre de couches de matériau nanocristallin (16,17).

7. Dispositif de mesure selon la revendication 1 ou 2, **caractérisé en ce que** le noyau magnétique (20) est constitué par une pièce en forme de U comportant deux parties d'extrémités séparées par un entrefer, entre lesquelles est placée une bobine secondaire (21) de mesure du courant circulant dans l'appareillage électrique.

8. Dispositif de mesure selon la revendication 7, **caractérisé en ce que** ce noyau magnétique (20) est composé de trois branches (20a,20b,20c) soudées entre elles, ces trois branches étant formées par l'empilage de tôles.

9. Dispositif de mesure selon la revendication 8, **caractérisé en ce que** les branches du U sont réalisées en Fe Si 3 % à grain orienté (FGO).

10. Dispositif de mesure selon la revendication 1 ou 2, **caractérisé en ce que** le noyau magnétique précité (8) est composé de deux I (9,10) séparés formant entre eux à leurs extrémités, deux entrefers, chaque I étant apte à canaliser le flux magnétique, chaque entrefer étant formé par deux parties d'extrémités en regard des deux I, chaque entrefer recevant une bobine secondaire de mesure (13,14) disposée entre deux parties d'extrémités en regard appartenant respectivement aux deux I.

11. Dispositif de mesure selon la revendication 10, **caractérisé en ce que** chaque I est formé par l'empilage de tôles, réalisées en FeSi 3% à grain orienté (HGO).

12. Dispositif de mesure selon la revendication 10 ou 11, **caractérisé en ce que** l'extrémité des branches des I dépasse les bobines d'une longueur sensiblement égale à la largeur du circuit magnétique de manière à minimiser l'influence possible des champs magnétiques extérieurs.

13. Dispositif de mesure selon l'une quelconque des revendications précédentes, **caractérisé en ce que** les fiches (22,23) sont reliées électriquement à une carte électronique (26) comportant les moyens de mesure de la tension précités.

14. Dispositif de mesure selon l'une quelconque des revendications précédentes, **caractérisé en ce qu'**au moins une partie des éléments situés à l'intérieur du boîtier dit premier, sont enrobés dans une résine à forte tenue diélectrique permettant de réduire les distances d'isolement à l'intérieur dudit boîtier.

15. Dispositif de mesure selon l'une quelconque des revendications 1à 14, **caractérisé en ce que** l'appareillage électrique est un appareil de protection électrique modulaire destiné à être monté sur un rail de support.

16. Appareil de protection électrique comportant un dispositif de mesure selon l'une quelconque des revendications 1 à 15.

## Patentansprüche

1. Vorrichtung zum Messen mindestens einer elektrischen Größe, umfassend den elektrischen Strom, der in einem ersten elektrischen Gerät zirkuliert, wobei das elektrische Gerät dazu bestimmt ist, auf einem Montageträger montiert zu sein, wobei diese Vorrichtung zum Messen in einem ersten Gehäuse (1) aufgenommen ist, das eine im Wesentlichen quaderförmige Form aufweist und eine Breite aufweist, die im Wesentlichen gleich jener des Geräts ist, und eine Höhe aufweist, die es gestattet, es zwischen zwei Zeilen von Geräten zu integrieren, die jeweils auf zwei Schienen in einem Schaltschrank montiert sind, das erste Gehäuse umfassend eine bestimmte Anzahl von Durchgangsöffnungen (2, 3), die Anschlüsse bilden, die von einem Abschnitt begrenzt sind, der aus isolierendem Material hergestellt ist, wobei diese Anzahl der Anzahl von Phasen des Geräts entspricht, wobei die Öffnungen (2, 3) dazu bestimmt sind, jeweils von einem Leiter (6) durchquert zu werden, wobei die Leiter (6) dazu bestimmt sind, an einem ihrer Enden jeweils mit den Bereichen (37) der Anschlüsse des ersten Geräts und an ihrem gegenüberliegenden Ende mit den elektrischen Bereichen eines zweiten Geräts verbunden zu sein, das sich stromab oder stromauf des ersten Geräts befindet, und, für mindestens einen der Anschlüsse der Vorrichtung, einen magnetischen Kern (8, 15, 20), der den Anschluss zumindest teilweise umgibt und mindestens einen Luftspalt aufweist, um welchen mindestens eine sekundäre Spule zum Messen (13, 14, 18, 19, 21) gewickelt ist, wobei die Spule(n) zum Messen ein Signal liefert/liefern, das für den Strom repräsentativ ist, der in dem Gerät zirkuliert, **dadurch gekennzeichnet, dass** die Spule(n) zwischen zwei Endabschnitten des magnetischen Kerns (8, 15, 20) gewickelt ist/sind, der den Luftspalt begrenzt, und dadurch, dass das erste Gehäuse (1) geeignet ist, abnehmbar an einen zweiten Gehäuse befestigt zu sein, das zu dem ersten Gerät gehört, wobei das erste Gehäuse (1) zwei Stecker (22, 23) umfasst, die von einer Außenseite des ersten Gehäuses (1) hervorstehen, wobei die Stecker (22, 23) einerseits dazu bestimmt sind, durch ein erstes ihrer Enden den Spannungsabgriff an den Bereichen (37) der Anschlüsse (22) des ersten Geräts zu gestatten, und andererseits den Halt des ersten Gehäuses (1) bezogen auf das zweite Gehäuse des Geräts sicherzustellen, wobei die Stecker (22, 23) mit ihrem gegenüberliegenden Ende mit Mitteln zum Messen der Spannung elektrisch verbunden sind.

2. Vorrichtung zum Messen nach Anspruch 1, **dadurch gekennzeichnet, dass** der/die Abschnitt(e), der/die die Durchgangsöffnung(en) begrenzt/begrenzen, einen U-förmigen Querabschnitt aufweist/aufweisen.

3. Vorrichtung zum Messen nach Anspruch 1 oder 2, **dadurch gekennzeichnet, dass** der magnetische Kern (15) zwei Us (16, 17) umfasst, die durch zwei Luftspalten getrennt sind, wobei eine sekundäre Spule zum Messen (18, 19) um jeden der zwei Luftspalte herum platziert ist, wobei die Spulen in Reihe geschaltet sind und ein Signal liefern, das für den Strom repräsentativ ist, der in dem elektrischen Gerät zirkuliert.

4. Vorrichtung zum Messen nach Anspruch 3, **dadurch gekennzeichnet, dass** die magnetischen Us (16, 17) mit einem runden gezogenen Draht hergestellt sind, der einen Durchmesser von ungefähr 1 mm aufweist.

5. Vorrichtung zum Messen nach Anspruch 3 oder 4, **dadurch gekennzeichnet, dass** die magnetischen Us (16, 17) aus FeSi oder aus FeNi hergestellt sind.

6. Vorrichtung zum Messen nach einem der Ansprüche 3 bis 5, **dadurch gekennzeichnet, dass** die magnetischen Us durch Stapeln einer bestimmten Anzahl von Schichten aus nanokristallinem Material (16, 17) hergestellt sind.

7. Vorrichtung zum Messen nach Anspruch 1 oder 2, **dadurch gekennzeichnet, dass** der magnetische Kern (20) von einem U-förmigen Teil gebildet ist, das zwei Endabschnitte umfasst, die durch einen Luftspalt getrennt sind, zwischen denen eine sekundäre Spule (21) zum Messen des Stroms, der in dem elektrischen Gerät zirkuliert, platziert ist.

8. Vorrichtung zum Messen nach Anspruch 7, **dadurch gekennzeichnet, dass** der magnetische Kern (20) von drei Zweigen (20a, 20b, 20c) gebildet ist, die miteinander verschweißt sind, wobei diese drei Zweige durch das Stapeln von Blechen gebildet sind.

9. Vorrichtung zum Messen nach Anspruch 8, **dadurch gekennzeichnet, dass** die Zweige des Us aus kornorientiertem FeSi 3 % (HGO) hergestellt sind.

10. Vorrichtung zum Messen nach Anspruch 1 oder 2, **dadurch gekennzeichnet, dass** der magnetische Kern (8) aus zwei getrennten Is (9, 10) zusammengesetzt ist, die untereinander an ihren Enden zwei Luftspalte bilden, wobei jedes I geeignet ist, den magnetischen Fluss zu kanalisieren, wobei jeder Luftspalt von zwei Endabschnitten gegenüber den zwei Is gebildet ist, wobei jeder Luftspalt eine sekundäre Spule zum Messen (13, 14) aufnimmt, die zwischen zwei gegenüberliegenden Endabschnitten angeordnet sind, die jeweils zu den zwei Is gehören.

11. Vorrichtung zum Messen nach Anspruch 10, **dadurch gekennzeichnet, dass** jedes I durch das Stapeln von Blechen gebildet ist, die aus kornorientiertem FeSi 3% (HGO) hergestellt sind.

12. Vorrichtung zum Messen nach Anspruch 10 oder 11, **dadurch gekennzeichnet, dass** das Ende der Zweige der Is um eine Länge über die Spulen hinausgeht, die im Wesentlichen gleich der Breite des magnetischen Kreises ist, um den möglichen Einfluss der äußeren Magnetfelder zu minimieren.

13. Vorrichtung zum Messen nach einem der vorhergehenden Ansprüche, **dadurch gekennzeichnet, dass** die Stecker (22, 23) mit einer elektronischen Karte (26) elektrisch verbunden sind, die die Mittel zum Messen der Spannung umfasst.

14. Vorrichtung zum Messen nach einem der vorhergehenden Ansprüche, **dadurch gekennzeichnet, dass** mindestens ein Teil der Elemente, die sich innerhalb des ersten Gehäuses befinden, von einem Harz mit hoher dielektrischer Festigkeit umhüllt ist, das es gestattet, die Isolierungsabstände innerhalb des Gehäuses zu verringern.

15. Vorrichtung zum Messen nach einem der Ansprüche 1 bis 14, **dadurch gekennzeichnet, dass** das elektrische Gerät ein modulares elektrisches Schutzgerät ist, das dazu bestimmt ist, auf einer Trageschiene montiert zu sein.

16. Elektrisches Schutzgerät, umfassend eine Vorrichtung zum Messen nach einem der Ansprüche 1 bis 15.

## Claims

1. Device for measuring at least one electrical quantity including the electric current flowing through an electrical unit referred to as the first unit, said unit being intended to be mounted on a mounting support, this measurement device being housed in a housing referred to as the first housing (1) which is substantially parallelepipedal in shape and the width of which is substantially equal to that of the aforementioned unit and the height of which allows it to be integrated between two rows of units mounted respectively on two rails in an electrical enclosure, said housing referred to as the first housing including a certain number of through-openings (2, 3) forming terminals delimited by a portion made of an insulating material, this number corresponding to the number of phases of the unit, said openings (2, 3) each being intended to have a conductor (6) pass therethrough, said conductors (6) being intended to be electrically linked by one of their ends to the lands (37) of the terminals of the unit referred to as the first unit, and by their opposite end to the electrical lands of a unit referred to as the second unit located downstream or even upstream of said unit referred to as the first unit, and, for at least one of said terminals of the device, a magnetic core (8, 15, 20) at least partially surrounding said terminal and including at least one air gap around which at least one measurement coil referred to as the secondary coil (13, 14, 18, 19, 21) is wound, said one or more measurement coils delivering a signal representing the current flowing through the unit,
**characterized in that** the one or more coils are wound between the two end portions of the magnetic core (8, 15, 20) delimiting said air gap, and **in that** the housing referred to as the first housing (1) is capable of being removably attached to a housing referred to as the second housing belonging to the unit referred to as the first unit, the aforementioned housing referred to as the first housing (1) including two connectors (22, 23) protruding from an outside face of said housing referred to as the first housing (1), said connectors (22, 23) being intended, via one of their ends referred to as the first end, to connect to the voltage on the lands (37) of the terminals (22) of the unit referred to as the first unit, and to secure the housing (1) referred to as the first housing with respect to the housing referred to as the second housing of the unit, said connectors (22, 23) being electrically connected by their opposite end to means for measuring the voltage.

2. Measurement device according to Claim 1, **characterized in that** the aforementioned one or more portions delimiting the one or more through-openings have a U-shaped cross section.

3. Measurement device according to Claim 1 or 2, **characterized in that** the aforementioned magnetic core (15) includes two U-shapes (16, 17) separated by two air gaps, a secondary measurement coil (18, 19) being placed around each of the two air gaps, said coils being connected in series and delivering a signal that is representative of the current flowing through the electrical unit.

4. Measurement device according to Claim 3, **characterized in that** the aforementioned magnetic U-shapes (16, 17) are made using a drawn round wire having a diameter of about 1 mm.

5. Measurement device according to Claim 3 or 4, **characterized in that** the magnetic U-shapes (16, 17) are made of FeSi or of FeNi.

6. Measurement device according to any one of Claims 3 to 5, **characterized in that** the magnetic U-shapes are made by stacking a certain number of layers of nanocrystalline material (16, 17).

7. Measurement device according to Claim 1 or 2, **characterized in that** the magnetic core (20) consists of a U-shaped part including two end portions separated by an air gap, between which a secondary coil (21) for measuring the current flowing through the electrical unit is placed.

8. Measurement device according to Claim 7, **characterized in that** the magnetic core (20) is composed of three branches (20a, 20b, 20c) that are welded together, these three branches being formed by stacking sheets.

9. Measurement device according to Claim 8, **characterized in that** the branches of the U-shape are made of grain-oriented 3%-Si FeSi (GOES).

10. Measurement device according to Claim 1 or 2, **characterized in that** the aforementioned magnetic core (8) is composed of two separate I-shapes (9, 10) forming between them, at their ends, two air gaps, each I-shape being capable of channelling the magnetic flux, each air gap being formed by two facing end portions of the two I-shapes, each air gap receiving a secondary measurement coil (13, 14) that is arranged between two facing end portions belonging to the two I-shapes, respectively.

11. Measurement device according to Claim 10, **characterized in that** each I-shape is formed by stacking sheets made of grain-oriented 3%-Si FeSi (GOES).

12. Measurement device according to Claim 10 or 11, **characterized in that** the end of the branches of the I-shapes extends beyond the coils by a length that is substantially equal to the width of the magnetic circuit so as to minimize the possible influence of external magnetic fields.

13. Measurement device according to any one of the preceding claims, **characterized in that** the connectors (22, 23) are electrically linked to an electronic board (26) including the aforementioned means for measuring the voltage.

14. Measurement device according to any one of the preceding claims, **characterized in that** at least a portion of the elements located inside the housing referred to as the first housing are coated in a resin having high dielectric strength, making it possible to decrease the insulation distances inside said housing.

15. Measurement device according to any one of Claims 1 to 14, **characterized in that** the electrical unit is a modular electrical protection unit intended to be mounted on a support rail.

16. Electrical protection unit including a measurement device according to any one of Claims 1 to 15.
